# EUROPÄISCHE PATENTSCHRIFT

(11) **EP 4 086 954 B1**
(45) Veröffentlichungstag und Bekanntmachung des Hinweises auf die Patenterteilung: **26.02.2025**
(21) Anmeldenummer: 21172724.3
(22) Anmeldetag: 07.05.2021
(51) Int. Cl.: H01R 12/52, H01R 12/57, H01R 12/58, H01R 12/91, H01L 23/498, H05K 1/14

(54) **LEISTUNGSHALBLEITERBAUGRUPPE MIT EINEM EINPRESSKONTAKTELEMENT MIT EINEM AUSGLEICHSABSCHNITT UND EINEM BLOCKIERABSCHNITT**
POWER SEMICONDUCTOR MODULE WITH A PRESS-IN CONTACT ELEMENT WITH A COMPENSATION SECTION AND A BLOCKING SECTION
ENSEMBLE SEMI-CONDUCTEUR DE PUISSANCE COMPRENANT ÉLÉMENT DE CONTACT À PRESSER DOTÉ D'UNE SECTION DE COMPENSATION ET D'UNE SECTION DE BLOCAGE

(43) Veröffentlichungstag der Anmeldung: 09.11.2022
(73) Patentinhaber: SEMIKRON Elektronik GmbH & Co. KG, 90431 Nürnberg (DE)
(72) Erfinder: Cardi, Valeriano, 00165 Rom (IT); Ehler, Ralf, 91459 Markt Erlbach (DE)

(56) Entgegenhaltungen:
- DE-A1- 102009 002 999
- US-A1- 2015 364 847

## Beschreibung

Die Erfindung beschreibt eine Leistungshalbleiterbaugruppe mit mindestens einem Einpresskontaktelement, mit einem Einpressabschnitt, einem Verbindungsabschnitt, einem Ausgleichsabschnitt, einem Fußabschnitt und einem Blockierabschnitt. Weiterhin beschreibt die Erfindung ein Leistungshalbleitermodul mit einer derartigen Leistungshalbleiterbaugruppe.

Die DE 10 2008 007 310 A1 offenbart einen elektrischen Einpresskontakt, insbesondere Einpressstiftkontakt, zur Übertragung von elektrischem Strom und/oder elektrischen Signalen, mit einem Einpressabschnitt und einem Montageabschnitt, die über einen Entlastungsabschnitt miteinander mechanisch gekoppelt sind, und der Entlastungsabschnitt einen Ausgleichsbereich und einen Anschlagbereich aufweist, wobei der Ausgleichsbereich eine gekoppelte Relativbewegung des Einpressabschnitts und des Montageabschnitts zulässt und der Anschlagbereich eine Aufeinanderzubewegung von Einpressabschnitt und Montageabschnitt blockiert.

Die US 2015/364847 A1 offenbart einen Pin für ein Halbleitergehäuse, welcher einen oberen Kontaktabschnitt mit einer Kontaktfläche enthält, die so konfiguriert ist, dass sie mechanisch und elektrisch mit einer Stiftaufnahme gekoppelt ist. Ein unterer Abschnitt des Stifts ist so konfiguriert, dass er sich biegt, damit sich ein oberer Abschnitt des Stifts in Richtung einer oberen Kontaktfläche einer horizontalen Basis des Stifts als Reaktion auf einen Druck bewegen kann, der entlang einer Richtung ausgeübt wird, die kollinear zu einer längsten Länge des Stifts in Richtung der oberen Kontaktfläche der horizontalen Basis verläuft, wenn der Stift in eine Stiftaufnahme eingeführt wird.

In Kenntnis des Standes der Technik liegt der Erfindung die Aufgabe zugrunde, eine alternative Ausgestaltung einer Leistungshalbleiterbaugruppe mit mindestens einem Einpresskontaktelement und ein Leistungshalbleitermodul mit einer derartigen Leistungshalbleiterbaugruppe vorzustellen, wobei der Herstellungsaufwand des Einpresskontaktelements verringert wird.

Diese Aufgabe wird erfindungsgemäß gelöst durch eine Leistungshalbleiterbaugruppe mit einem Substrat und auf dessen Isolierstoffkörper angeordneten Leiterbahnen und mit einem Einpresskontaktelement mit einem Einpressabschnitt, einem Verbindungsabschnitt, einem Ausgleichsabschnitt, einem Fußabschnitt und einem Blockierabschnitt, wobei der Ausgleichsabschnitt elastisch ausgestaltet und dazu ausgebildet ist bei einer Längsbewegung des Einpressabschnitts in einer Längsrichtung des Einpresskontaktelements auf den Fußabschnitt hin gestaucht zu werden und somit seine Längenausdehnung zu verringern, wobei der Fußabschnitt stoffschlüssig auf einem Abschnitt einer dieser Leiterbahnen des Substrats angeordneten Einpresskontaktelement und wobei der Blockierabschnitt dazu ausgebildet und vorgesehen ist, sich mit einer Blockierfläche auf einer Blockiergegenfläche abzustützen und damit die Längsbewegung des Einpressabschnitts in Längsrichtung auf den Fußabschnitt hin zu begrenzen, wobei die Blockiergegenfläche angeordnet ist auf einem Isolierstoffkörper des Substrats oder auf einer Leiterbahn des Substrats, insbesondere derjenigen Leiterbahn, auf der auch der Fußabschnitt angeordnet ist.

Entscheidend und erfindungswesentlich hierbei ist, dass das Einpresskontaktelement selbst keine Blockiergegenfläche aufweist.

Unter dem Begriff "Längsrichtung" soll hier und im Folgenden diejenige Richtung verstanden werden, die der Richtung des Einpressens des Einpressabschnitts in eine korrespondierende Öffnung, beispielhaft als Teil einer Leiterplatte oder eines sonstigen stromleitenden Elements, wie einer Anschlussschiene, entgegengesetzt ist. Die Längsrichtung entspricht also einer negativen Einpressrichtung.

Es kann vorteilhaft sein, wenn der Verbindungsabschnitt eine erste und eine parallel dazu angeordnete und jeweils plan ausgebildete Hauptfläche aufweist.

Es kann weiterhin vorteilhaft sein, wenn der Ausgleichsabschnitt einen Bogen oder eine Mehrzahl von, vorzugsweise aneinander angrenzenden, Bögen aufweist. Insbesondere ist es vorteilhaft, wenn der Ausgleichsabschnitt S-förmig ausgebildet ist.

Dabei kann es bevorzugt sein, wenn ein erster Bogenabschnitt eines ersten Bogens des Ausgleichsabschnitts in Normalenrichtung über die erste Hauptfläche hervorsteht. Zudem kann es bevorzugt sein, wenn ein zweiter Bogenabschnitt eines zweiten Bogens des Ausgleichsabschnitts in Normalenrichtung über die zweite Hauptfläche hervorsteht.

Vorteilhafterweise ist das gesamte Einpresskontaktelement dafür vorgesehen mittels eines Stanzverfahrens aus einem flächigen Blech oder aus einem flächigen Metallband ausgebildet zu sein.

Es kann auch vorteilhaft sein, wenn der Blockierabschnitt stiftförmig ausgebildet ist und die Blockierfläche am, in Längsrichtung liegenden, Ende des Blockierabschnitts angeordnet ist. Vorzugsweise bildet die Längsrichtung hierbei die Flächennormale der Blockierfläche.

Insbesondere ist es bevorzugt, wenn der Blockierabschnitt als zwei Teilblockierabschnitte ausgebildet ist und der Ausgleichsabschnitt oder ein Abschnitt hiervon zwischen den beiden Teilblockierabschnitten angeordnet ist oder wenn der Ausgleichsabschnitt als zwei Teilausgleichsabschnitte ausgebildet ist und der Blockierabschnitt oder ein Abschnitt hiervon zwischen den beiden Teilausgleichsabschnitten angeordnet ist.

Auch ist es bevorzugt, wenn das Substrat ausgebildet ist mit einer Isolierkeramik als Träger der Leiterbahnen oder als eine starre Leiterplatte oder als eine flexible Leiterplatte.

Die o.g. Aufgabe wird ebenfalls erfindungsgemäß gelöst durch ein Leistungshalbleitermodul mit einem Gehäuse, mit einem davon umschlossenen Substrat und einer oben beschriebenen Leistungshalbleiterbaugruppe.

Es kann bevorzugt sein, wenn das Gehäuse eine Führungseinrichtung, insbesondere einen Schacht, aufweist, in dem der Verbindungsabschnitt zumindest teilweise und in Längsrichtung beweglich angeordnet ist.

Hierbei kann es vorteilhaft sein, wenn in einem Kanal ein Ausgleichsabschnitt eines Einpresskontaktelements angeordnet ist.

Selbstverständlich können, sofern dies nicht explizit oder per se ausgeschlossen ist oder dem Gedanken der Erfindung widerspricht, die jeweils im Singular genannten Merkmale, insbesondere der Fußabschnitt, mehrfach vorhanden sein. Ebenso, und sogar bevorzugt, kann das Einpresskontaktelement mehrfach auf der Leistungshalbleiterbaugruppe oder in dem Leistungshalbleitermodul vorhanden sein.

Es versteht sich, dass die verschiedenen Ausgestaltungen der Erfindung, gleichgültig ob sie im Rahmen der Beschreibung des Einpresskontaktelements oder der Leistungshalbleiterbaugruppe oder des Leistungshalbleitermoduls offenbart sind, einzeln oder in beliebigen Kombinationen realisiert sein können, um Verbesserungen zu erreichen. Insbesondere sind die vorstehend und im Folgenden genannten und erläuterten Merkmale nicht nur in den angegebenen Kombinationen, sondern auch in anderen Kombinationen oder in Alleinstellung einsetzbar, ohne den Rahmen der vorliegenden Erfindung zu verlassen.

Weitere Erläuterungen der Erfindung, vorteilhafte Einzelheiten und Merkmale, ergeben sich aus der nachfolgenden Beschreibung der in den Figuren 1 bis 7 schematisch dargestellten Ausführungsbeispiele der Erfindung oder von jeweiligen Teilen hiervon.
Figur 1 zeigt schematisch verschiedene Ansichten eines Einpresskontaktelements einer erfindungsgemäßen Leistungshalbleiterbaugruppe.
Figuren 2 bis 4 zeigen eine erste Ausgestaltung eines Einpresskontaktelements einer erfindungsgemäßen Leistungshalbleiterbaugruppe.
Figuren 5 bis 8 zeigen weitere Ausgestaltungen eines Einpresskontaktelements einer erfindungsgemäßen Leistungshalbleiterbaugruppe.

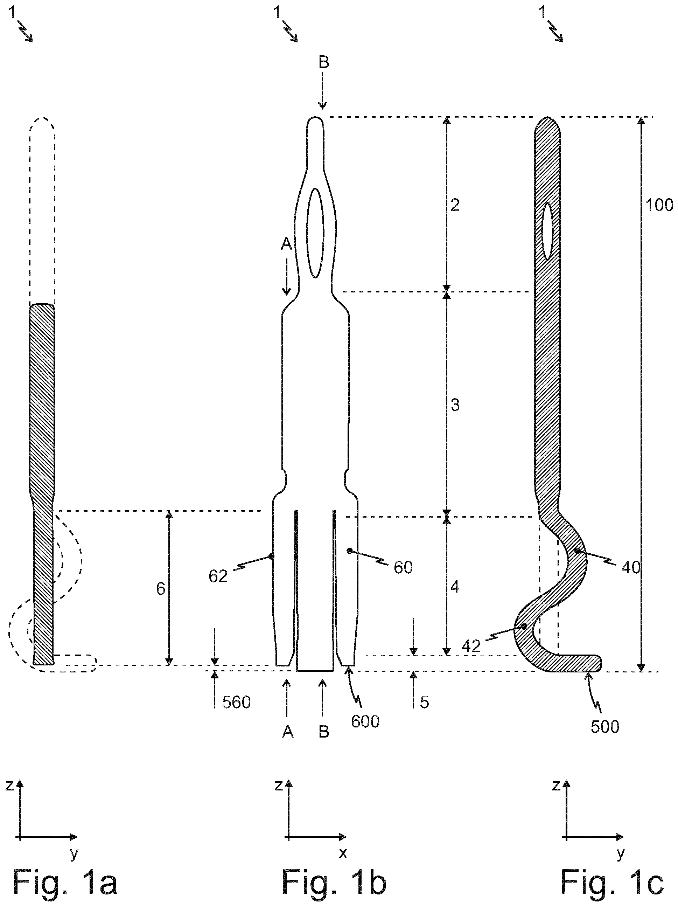

Figur 1 zeigt schematisch verschiedene Ansichten eines Einpresskontaktelements 1 einer erfindungsgemäßen Leistungshalbleiterbaugruppe mit einer Längsausdehnung 100 in z-Richtung, die gleichzeitig der Einpressrichtung entspricht. Hierbei zeigt Figur 1b eine Draufsicht aus y-Richtung, während Figur 1a einen Schnitt entlang der Linie A-A und eine Draufschicht auf diesen Schnitt in x-Richtung zeigt. Figur 1c zeigt einen entsprechenden Schnitt entlang der Linie B-B und ebenfalls eine Draufschicht auf diesen Schnitt in x-Richtung.

Das Einpresskontaktelement 1 der erfindungsgemäßen Leistungshalbleiterbaugruppe weist einen vorzugsweise fachüblichen Einpressabschnitt 2 und in negativer z-Richtung anschließend einen Verbindungsabschnitt 3 auf, der den Einpressabschnitt 2 mit einem Ausgleichsabschnitt 4 verbindet. An diesen Ausgleichsabschnitt 4 schließt sich ein Fußabschnitt 5 an, wobei der Ausgleichsabschnitt und der Fußabschnitt 5 direkt ineinander übergehen. In positive und negative x-Richtung weist das Einpresskontaktelement 1 noch jeweils einen Teilblockierabschnitt 60,62 auf, wobei die beiden Teilblockierabschnitte 60,62 gemeinsam einen Blockierabschnitt 6 ausbilden. Die Teilblockierabschnitte 60,62 sind vom Ausgleichsabschnitt 4 jeweils durch Ausnehmungen freigespart.

Der Ausgleichsabschnitt 4 selbst ist elastisch, insbesondere in Längsrichtung und damit auch in z-Richtung, ausgestaltet. Er ist hierzu S-förmig ausgebildet mit zwei ineinander übergehenden Bögen 40, 42. Durch diese Ausgestaltung ist der Ausgleichsabschnitt 4 dazu ausgebildet bei einer Längsbewegung des Einpressabschnitts 2 in der Längsrichtung, also der negativen z-Richtung, des Einpresskontaktelements 1 auf den Fußabschnitt 5 hin gestaucht zu werden und somit seine Längenausdehnung 100 in dem Ausgleichsabschnitt 4 zu verringern.

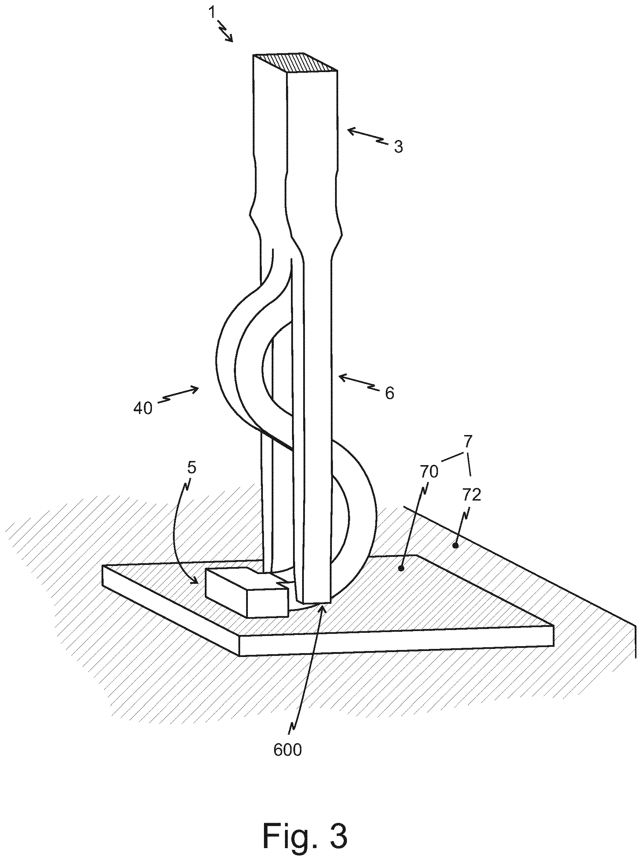

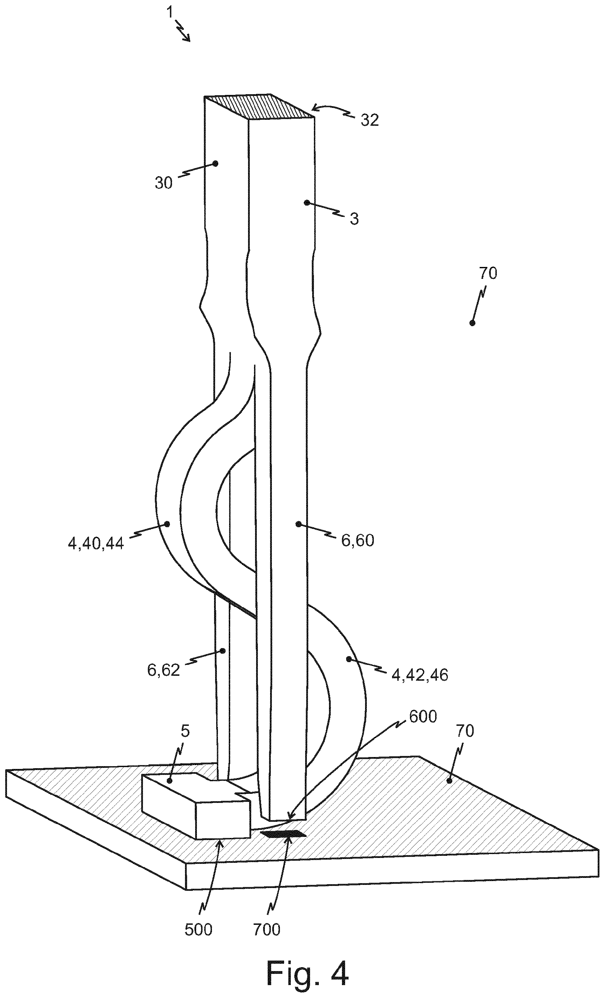

Der Fußabschnitt 5 ist dazu ausgebildet stoffschlüssig mit einer Fußfläche 500 auf einer Leiterbahn 70 eines Substrats 7 angeordnet zu werden, vgl. hierzu Figur 3 und 4. Diese stoffschlüssige Verbindung kann entweder mittels einer Schweißverbindung, also ohne zusätzliches, zwischen dem Fußabschnitt 5 und der Leiterbahn angeordnetes, Verbindungsmittel ausgebildet sein. Alternativ kann die stoffschlüssige Verbindung als Lot- oder Sinterverbindung ausgebildet sein, wobei sich dann ein Verbindungsmittel zwischen dem Fußabschnitt 5 und der Leiterbahn befindet. Die jeweilige stoffschlüssige Verbindung bestimmt die mögliche Reduktion der Längenausdehnung im Anwendungsfall, wie im Folgenden noch ausgeführt wird.

Der Blockierabschnitt 6 ist grundsätzlich dazu ausgebildet sich mit einer Blockierfläche 600 auf eine Blockiergegenfläche 700, vgl. Figur 4, abzustützen und somit die Längsbewegung des Einpressabschnitts 2 in Richtung auf den Fußabschnitt 5 zu begrenzen. Diese Blockiergegenfläche 700 kann grundsätzlich auf einem Isolierstoffkörper 72 des Substrats 7 oder auf einer Leiterbahn 70 des Substrats 7 angeordnet sein. Auch diese Ausgestaltung beeinflusst die mögliche Reduktion der Längenausdehnung im Anwendungsfall.

In der hier dargestellten Ausgestaltung des Einpresskontaktelements 1 ist die jeweilige Blockierfläche 600 um einen Versatz 560 in z-Richtung gegenüber der Fußfläche 500 in z-Richtung zurückversetzt. Falls nun diese Fußfläche 500 direkt auf der Leiterbahn angeordnet und mit dieser mittels der o.g. Schweißverbindung verbunden ist, entspricht der Versatz 560 genau der möglichen Reduktion der Längenausdehnung 100.

Für eine Anordnung der Fußfläche 500 mittels eines Verbindungsmittels auf der Leiterbahn ergibt sich eine größere mögliche Reduktion der Längenausdehnung 100, soweit die Blockiergegenfläche direkt auf der Leiterbahn ausgebildet ist.

Häufig steht die Leiterbahn gegenüber dem Isolierstoffkörper des Substrats in z-Richtung aus diesem hervor, was bei einer Anordnung der Blockiergegenfläche auf dem Isolierstoffkörper ebenfalls zu einer größeren möglichen Reduktion der Längenausdehnung 100 führt.

Diese Unterschiede führen bei der Auslegung der Dimensionen, insbesondere des Versatzes 560 dazu, dass die Ausgestaltung der Verbindung des Einpresskontaktelements 1 mit dem Substrat und die Lage der Blockiergegenfläche, berücksichtig werden müssen. Andererseits hat diese Ausgestaltung des Einpresskontaktelements 1, bei der die Blockiergegenfläche nicht integraler Teil des Einpresskontaktelements 1 selbst ist, den Vorteil, dass der Fertigungsaufwand für das Einpresskontaktelement 1, insbesondere im Rahmen eines Stanz-Biege-Verfahrens, geringer ist verglichen mit dem Stand der Technik.

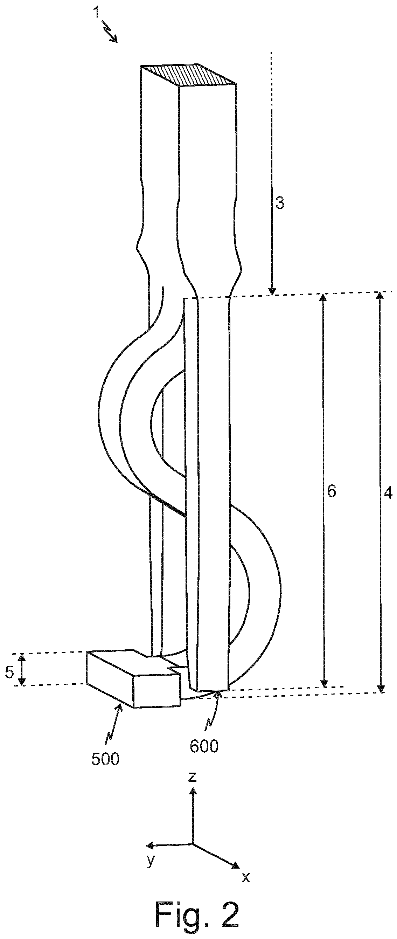

Figuren 2 bis 4 zeigen eine erste Ausgestaltung eines Einpresskontaktelements 1 einer erfindungsgemäßen Leistungshalbleiterbaugruppe, genauer einen Abschnitt hiervon, und in den Figuren 3 und 4 dessen Anordnung auf einem Substrat 7 als Teil einer Leistungshalbleiterbaugruppe oder eines Leistungshalbleitermoduls.

Das dargestellte Einpresskontaktelement 1 ist im Grunde ähnlich demjenigen gemäß Figur 1 aufgebaut. Es weist einen nicht dargestellten, fachüblich ausgebildeten Einpressabschnitt 2 und in negativer z-Richtung anschließend einen Verbindungsabschnitt 3 auf, der eine erste und eine zweite, parallel dazu angeordnete, und jeweils plan ausgebildete Hauptfläche 30,32 aufweist, deren Normalenrichtung in positive bzw. negative y-Richtung verläuft.

An den Verbindungsabschnitt 3 schließt sich dann ein Ausgleichsabschnitt 4 an. Hieran schließt sich unmittelbar ein Fußabschnitt 5 an, wobei der Fußabschnitt, zumindest an dessen Ende, breiter ausgebildet ist als der Ausgleichsabschnitt 4. Der Fußabschnitt 5 ist dazu ausgebildet stoffschlüssig mit seiner Fußfläche 500 auf einer Leiterbahn 70 eines Substrats 7 angeordnet zu werden. Diese stoffschlüssige Verbindung kann wie oben beschrieben ausgebildet sein. In den Figuren 3 und 4 dargestellt ist, ohne Beschränkung der Allgemeinheit, eine stoffschlüssige Verbindung ohne explizites Verbindungsmittel.

Der Ausgleichsabschnitt 4 selbst ist elastisch ausgestaltet. Er ist hierzu S-förmig ausgebildet mit zwei ineinander übergehenden, also aneinander angrenzenden, Bögen 40,42. Hierbei steht ein erster Bogenabschnitt 44 des ersten Bogens 40 in Normalenrichtung über die erste Hauptfläche 30 hervor, während ein zweiter Bogenabschnitt 46 des zweiten Bogens 42 in Normalenrichtung über die zweite Hauptfläche 32 hervorsteht. Durch diese Ausgestaltung ist der Ausgleichsabschnitt 4 dazu ausgebildet bei einer Längsbewegung des Einpressabschnitts 2 in einer Längsrichtung, hier der negativen z-Richtung, des Einpresskontaktelements 1 auf den Fußabschnitt 5 hin gestaucht zu werden und somit seine Längenausdehnung 100, vgl. Figur 1, zu verringern.

Erfindungsgemäß weist das Einpresskontaktelement 1 der Leistungshalbleiterbaugruppe noch einen Blockierabschnitt 6 auf. Dieser ist ausgebildet als zwei Teilblockierabschnitte 60,62, wobei der Ausgleichsabschnitt 4 fast vollständig zwischen den beiden Teilblockierabschnitten 60,62 angeordnet ist. Der Blockierabschnitt 6, hier jeweils beide Teilblockierabschnitte 60,62, sind stiftförmig ausgebildet. Beide Teilblockierabschnitte 60,62 weisen eine Blockierfläche 600 an ihrem in Längsrichtung liegenden und damit dem Substrat zugewandten Ende auf. Die jeweilige Blockierfläche 600 ist parallel zu einer zugeordneten Blockiergegenfläche 700 orientiert.

Die erfindungsgemäße, in einem Ausschnitt dargestellte Leistungshalbleiterbaugruppe gemäß Figur 3 und 4 ist als ein Teil eines Leistungshalbleitermoduls ausgebildet. Sie weist ein Substrat 7 und eine Mehrzahl von Einpresskontaktelementen 1, wobei nur eines exemplarisch dargestellt ist, auf. Das Substrat 7 selbst weist hier ohne Beschränkung der Allgemeinheit einen starren Isolierstoffkörper 72 und hierauf eine Mehrzahl von Leiterbahnen 70, wobei ebenfalls nur eine dargestellt ist, auf. Das Einpresskontaktelement 1 ist mit seinem Fußabschnitt 5 stoffschlüssig auf einem Abschnitt einer dieser Leiterbahnen 70 angeordnet und stoffschlüssig damit verbunden.

Ohne Kraftbeaufschlagung in Längsrichtung des Einpresskontaktelements 1 weist die Blockierfläche 600 des jeweiligen Teilblockierabschnitts 60,62 einen Abstand zur Oberfläche der Leiterbahn 70 und der dort ausgebildeten Blockiergegenfläche auf. Grundsätzlich ist die Blockiergegenfläche 700 ein Flächenabschnitt der Leiterbahn 70 als solcher. Es kann allerdings auch eine weitere Metallisierung auf der Leiterbahn 70 angeordnet sein, deren Oberfläche dann die Blockiergegenfläche ausbildet. Eine derartige Metallisierung kann beispielhaft eine Lotschicht oder eine Sintermetallschicht sein, insbesondere dann, wenn auch die stoffschlüssige Verbindung des Fußabschnitts 5 mit der Leiterbahn 70 als Lot- oder Sinterverbindung ausgebildet ist.

Der Blockierabschnitt 6 bzw. hier die beiden Teilblockierabschnitte 60,62 dienen in Zusammenwirkung mit den jeweils zugeordneten Blockiergegenflächen 700 des Substrats 7 dazu bei einer Bewegung des Einpressabschnitts 2, insbesondere im Rahmen des Einpressverfahrens, in Längsrichtung auf den Fußabschnitt 5 oder das Substrat 7 zu sich mit seiner jeweiligen Blockierfläche 600 auf der zugeordneten Blockiergegenfläche 700 abzustützen und damit die Längsbewegung des Einpressabschnitts 2 in Längsrichtung zu begrenzen. Diese Begrenzung ist erreicht, sobald die jeweilige Blockierfläche 600 auf der zugeordneten Blockiergegenfläche 700 flächig aufliegt.

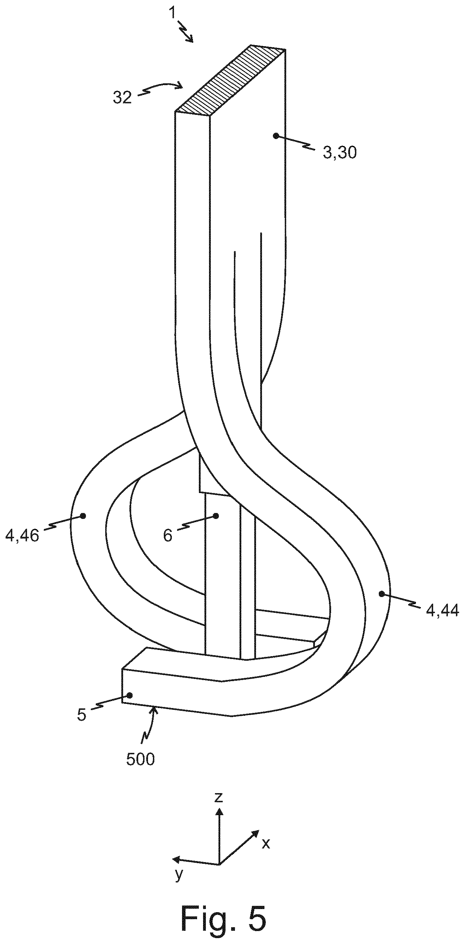

Die Figuren 5 bis 8 zeigen weitere Ausgestaltungen eines erfindungsgemäßen Einpresskontaktelements 1. Dargestellt ist jeweils nur ein Teil des Verbindungsabschnitts 3, an den sich jeweils ein Ausgleichsabschnitt 4 und daran ein Fußabschnitt 5 anschließt. Der Einpressabschnitt selbst ist nicht dargestellt, da dessen Ausgestaltung prinzipiell beliebig ist.

Dargestellt in Figur 5 ist ein Ausgleichsabschnitt 4, der als zwei Teilausgleichsabschnitte ausgebildet ist. Diese beiden Teilausgleichsabschnitte sind jeweils mit einem Bogen ausgebildet, wobei ein erster Bogenabschnitt 44 des ersten Bogens des ersten Teilausgleichsabschnitts in Normalenrichtung über eine erste Hauptfläche 30 des Verbindungsabschnitts 3 hervorsteht. Entsprechend steht ein zweiter Bogenabschnitt 46 des zweiten Bogens des zweiten Teilausgleichsabschnitts in Normalenrichtung über eine zweite Hauptfläche 32 des Verbindungsabschnitts 3 hervor. Beide Bögen enden unmittelbar in einem jeweiligen Fußabschnitt 5, der sich somit an die jeweiligen Teilausgleichsabschnitte unmittelbar anschließt.

Die beiden Bögen sind in y-Richtung nebeneinander und beabstandet voneinander angeordnet. Ein stiftartiger Blockierabschnitt 6 ist zwischen den beiden Teilausgleichsabschnitten angeordnet. Diese Ausgestaltung des Einpresskontaktelements 1 ist somit sehr kompakt ausgebildet. Weiterhin wirken in negative und positive x- und y-Richtung jeweils gleiche Kräfte auf das Einpresskontaktelement 1, wenn eine Längsbewegung des Einpressabschnitts in Längsrichtung auf die Fußabschnitte 5 erfolgt. Selbstverständlich weist der Blockierabschnitt 6 eine funktional wie oben beschriebene Blockierfläche 600 auf.

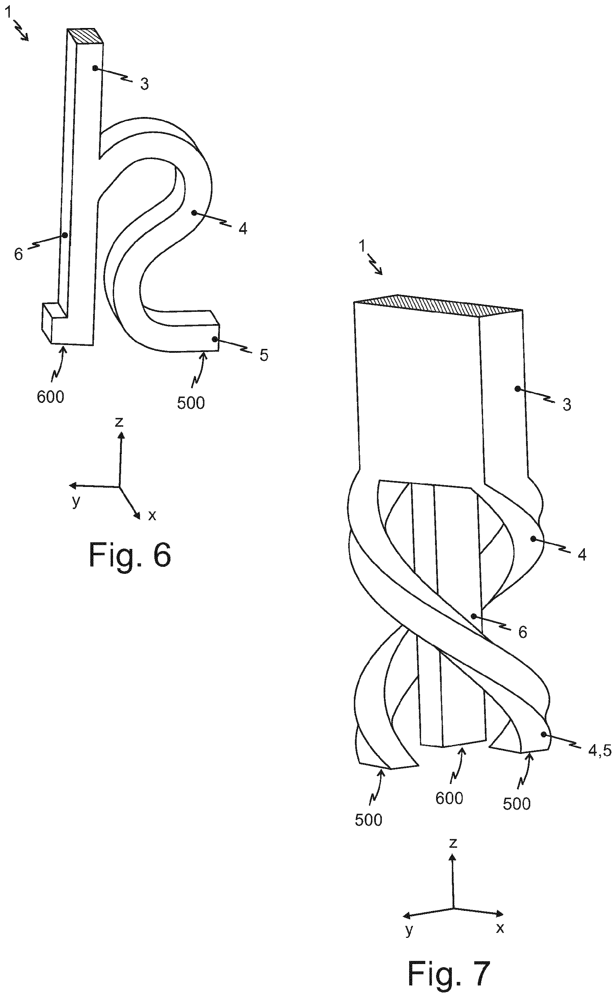

Figur 6 zeigt eine weitere Variante eines Einpresskontaktelements 1, wobei wiederum auf die Darstellung des Einpressabschnitts verzichtet wurde. Bei dieser Ausgestaltung geht der Verbindungsabschnitt 3 in Längsrichtung, also negative z-Richtung, direkt in den Blockierabschnitt 6 über. Der Ausgleichsabschnitt 4 steht in negativer y-Richtung aus der Einheit aus Verbindungs- und Blockierabschnitt 3,6 heraus, ist S-förmig ausgebildet und weist an seinem Ende direkt den Fußabschnitt 5 auf.

Figur 7 zeigt eine weitere Variante eines Einpresskontaktelements 1, wobei wiederum auf die Darstellung des Einpressabschnitts verzichtet wurde. Diese Ausgestaltung ähnelt derjenigen gemäß Figur 5. Allerdings sind hier die beiden Teilausgleichsabschnitte nicht S-förmig ausgebildet. Vielmehr winden sich die beiden Teilausgleichsabschnitte in dem zentralen Blockierabschnitt 6 herum und sind zudem noch in sich verdreht.

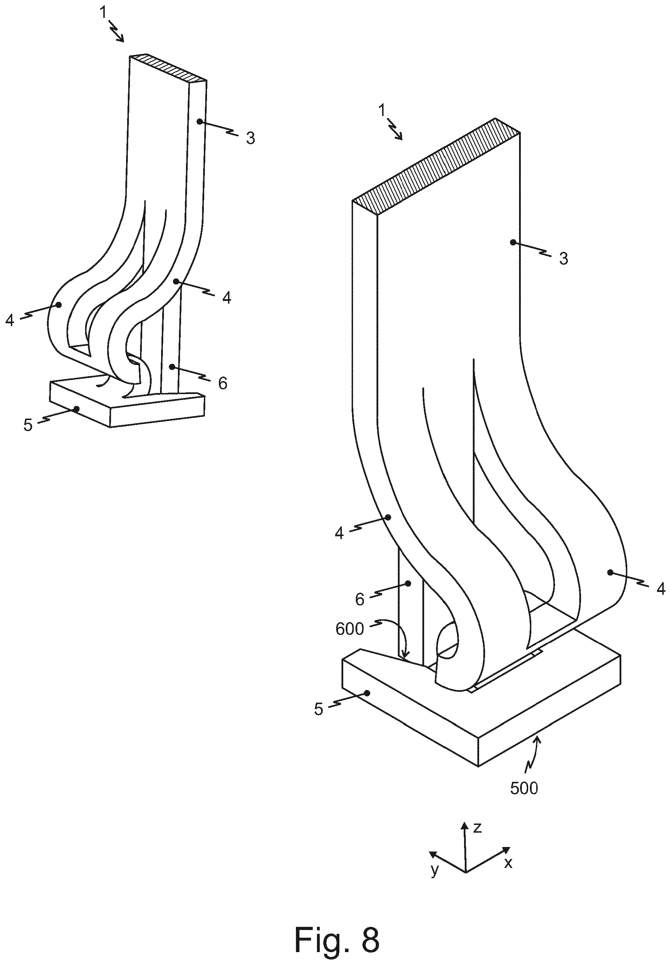

Figur 8 zeigt in zwei Ansichten jeweils eine weitere Variante eines Einpresskontaktelements 1, wobei wiederum auf die Darstellung des Einpressabschnitts verzichtet wurde. Bei dieser Ausgestaltung geht der Verbindungsabschnitt 3 in den Ausgleichsabschnitt 4 über, wobei an diesem Übergang auch der Blockierabschnitt 6 ausgebildet wird. Dieser wird gebildet, indem ein flächiges Metallband, das als Ausgangsmaterial für das gesamte Einpresskontaktelement 1 dient, an genanntem Übergang in drei Bereiche aufgeteilt wird, die in x-Richtung nebeneinander angeordnet sind. Die beiden äußeren Bereiche bilden dann nach einem Biegeprozess den Ausgleichsabschnitt 4, während der zentrale Bereich den Blockierabschnitt 6 ausbildet. Der Blockierabschnitt 6 wurde hier also zungenartig freigestanzt.

Der Querschnitt des Ausgleichsabschnitts 4, der von den beiden äußeren Bereichen im weiteren Verlauf wieder zu einem Bereich wird, weist in diesem einen geringeren Querschnitt auf als im vorhergehenden Bereich.

An den Ausgleichsabschnitt 4 schließt sich der Fußabschnitt 5 an, der im oben beschriebenen Stanz-Biege-Prozess ebenfalls ausgebildet wird. Dies ist derart gestaltet, dass in x-Richtung betrachtet zwei Teile dieses Fußabschnitts 5 mit dem Blockierabschnitt 6 fluchten.

## Patentansprüche

1. Leistungshalbleiterbaugruppe mit einem Substrat (7) und auf dessen Isolierstoffkörper (72) angeordneten Leiterbahnen (70) und mit einem Einpresskontaktelement (1) mit einem Einpressabschnitt (2), einem Verbindungsabschnitt (3), einem Ausgleichsabschnitt (4), einem Fußabschnitt (5) und einem Blockierabschnitt (6), wobei der Ausgleichsabschnitt (4) elastisch ausgestaltet und dazu ausgebildet ist bei einer Längsbewegung des Einpressabschnitts in einer Längsrichtung des Einpresskontaktelements (1) auf den Fußabschnitt (5) hin gestaucht zu werden und somit seine Längenausdehnung (100) zu verringern, wobei der Fußabschnitt (5) stoffschlüssig auf einem Abschnitt einer dieser Leiterbahnen (70) des Substrats (7) angeordneten Einpresskontaktelement (1) und wobei der Blockierabschnitt (6) dazu ausgebildet und vorgesehen ist, sich mit einer Blockierfläche (600) auf einer Blockiergegenfläche (700) abzustützen und damit die Längsbewegung des Einpressabschnitts (2) in Längsrichtung auf den Fußabschnitt (5) hin zu begrenzen, **dadurch gekennzeichnet, dass** die Blockiergegenfläche (700) angeordnet ist auf einem Isolierstoffkörper (72) des Substrats (7) oder auf einer Leiterbahn (70) des Substrats (7), insbesondere derjenigen Leiterbahn (70), auf der auch der Fußabschnitt (5) angeordnet ist.

2. Leistungshalbleiterbaugruppe nach Anspruch 1, wobei
der Verbindungsabschnitt (3) des Einpresskontaktelements (1) eine erste und eine zweite parallel dazu angeordnete und jeweils plan ausgebildete Hauptfläche (30,32) aufweist.

3. Leistungshalbleiterbaugruppe nach einem der vorhergehenden Ansprüche, wobei
der Ausgleichsabschnitt (4) des Einpresskontaktelements (1) einen Bogen oder eine Mehrzahl von, vorzugsweise aneinander angrenzender, Bögen (40,42) aufweist.

4. Leistungshalbleiterbaugruppe nach Anspruch 3, wobei
der Ausgleichsabschnitt (4) des Einpresskontaktelements (1) S-förmig ausgebildet ist.

5. Leistungshalbleiterbaugruppenach Anspruch 2 bis 4, wobei
ein erster Bogenabschnitt (44) eines ersten Bogens (40) des Ausgleichsabschnitts (4) des Einpresskontaktelements (1) in Normalenrichtung über die erste Hauptfläche (30) hervorsteht.

6. Leistungshalbleiterbaugruppenach Anspruch 2 bis 5, wobei
ein zweiter Bogenabschnitt (46) eines zweiten Bogens (42) des Ausgleichsabschnitts (4) des Einpresskontaktelements (1) in Normalenrichtung über die zweite Hauptfläche (32) hervorsteht.

7. Leistungshalbleiterbaugruppe nach einem der vorhergehenden Ansprüche, wobei
das gesamte Einpresskontaktelement (1) mittels eines Stanzverfahrens aus einem flächigen Blech oder aus einem flächigen Metallband ausgebildet ist.

8. Leistungshalbleiterbaugruppe nach einem der vorhergehenden Ansprüche, wobei
der Blockierabschnitt (6) des Einpresskontaktelements (1) stiftförmig ausgebildet ist und die Blockierfläche (600) am in Längsrichtung liegenden Ende des Blockierabschnitts (6) angeordnet ist.

9. Leistungshalbleiterbaugruppe nach einem der vorhergehenden Ansprüche, wobei
der Blockierabschnitt (6) des Einpresskontaktelements (1) als zwei Teilblockierabschnitte (60,62) ausgebildet ist und der Ausgleichsabschnitt (4) oder ein Abschnitt hiervon zwischen den beiden Teilblockierabschnitten (60,62) angeordnet ist oder wobei der Ausgleichsabschnitt (4) als zwei Teilausgleichsabschnitte ausgebildet ist und der Blockierabschnitt (6) oder ein Abschnitt hiervon zwischen den beiden Teilausgleichsabschnitten angeordnet ist.

10. Leistungshalbleiterbaugruppe nach Anspruch einem der vorhergehenden Ansprüche, wobei
das Substrat ausgebildet ist mit einer Isolierkeramik als Träger der Leiterbahnen oder als eine starre Leiterplatte oder als eine flexible Leiterplatte.

11. Leistungshalbleitermodul mit einem Gehäuse, mit einem davon umschlossenen Substrat (7) und einer Leistungshalbleiterbaugruppe nach einem der Ansprüche 1 bis 10.

12. Leistungshalbleitermodul nach Anspruch 11, wobei
das Gehäuse eine Führungseinrichtung, insbesondere einen Schacht, aufweist, in dem der Verbindungsabschnitt (3) zumindest teilweise und in Längsrichtung beweglich angeordnet ist.

## Claims

1. Power semiconductor assembly having a substrate (7) and conductor tracks (70) arranged on the insulating-material body (72) of said substrate and having a press-in contact element (1) having a press-in portion (2), a connecting portion (3), a compensating portion (4), a foot portion (5) and a blocking portion (6), wherein the compensating portion (4) is configured to be elastic and is designed to be compressed upon a longitudinal movement of the press-in portion in a longitudinal direction of the press-in contact element (1) towards the foot portion (5) and therefore to reduce its longitudinal extent (100), wherein the foot portion (5) press-in contact element (1) arranged in a materially-bonded manner on a portion of one of these conductor tracks (70) of the substrate (7) and wherein the blocking portion (6) is designed and provided to be supported with a blocking surface (600) on a blocking counter-surface (700) and therefore to limit the longitudinal movement of the press-in portion (2) in the longitudinal direction towards the foot portion (5), **characterized in that**
the blocking counter-surface (700) is arranged on an insulating-material body (72) of the substrate (7) or on a conductor track (70) of the substrate (7), in particular that conductor track (70) on which the foot portion (5) is also arranged.

2. Power semiconductor assembly according to Claim 1, wherein
the connecting portion (3) of the press-in contact element (1) has a first and, arranged parallel thereto, a second main surface (30, 32), each being of planar design.

3. Power semiconductor assembly according to either of the preceding claims, wherein
the compensating portion (4) of the press-in contact element (1) has a curve or a plurality of, preferably mutually adjoining, curves (40, 42).

4. Power semiconductor assembly according to Claim 3, wherein
the compensating portion (4) of the press-in contact element (1) is of S-shaped design.

5. Power semiconductor assembly according to Claims 2 to 4, wherein
a first curve portion (44) of a first curve (40) of the compensating portion (4) of the press-in contact element (1) protrudes beyond the first main surface (30) in the normal direction.

6. Power semiconductor assembly according to Claims 2 to 5, wherein
a second curve portion (46) of a second curve (42) of the compensating portion (4) of the press-in contact element (1) protrudes beyond the second main surface (32) in the normal direction.

7. Power semiconductor assembly according to either of the preceding claims, wherein
the entire press-in contact element (1) is formed from a flat metal sheet or from a flat metal strip by means of a punching process.

8. Power semiconductor assembly according to either of the preceding claims, wherein
the blocking portion (6) of the press-in contact element (1) is designed in the form of a pin and the blocking surface (600) is arranged at the end of the blocking portion (6) which is located in the longitudinal direction.

9. Power semiconductor assembly according to either of the preceding claims, wherein
the blocking portion (6) of the press-in contact element (1) is designed as two blocking segments (60, 62) and the compensating portion (4) or a portion thereof is arranged between the two blocking segments (60, 62) or wherein the compensating portion (4) is designed as two compensating segments and the blocking portion (6) or a portion thereof is arranged between the two compensating segments.

10. Power semiconductor assembly according to any of the preceding claims, wherein
the substrate is designed with an insulating ceramic as a carrier of the conductor tracks or as a rigid printed circuit board or as a flexible printed circuit board.

11. Power semiconductor module having a housing, having a substrate (7) enclosed therein and a power semiconductor assembly according to any of Claims 1 to 10.

12. Power semiconductor module according to Claim 11, wherein
the housing has a guide device, in particular a shaft, in which the connecting portion (3) is at least partially arranged and such that it is movable in the longitudinal direction.

## Revendications

1. Ensemble semi-conducteur de puissance comprenant un substrat (7) et des pistes conductrices (70) agencées sur son corps isolant (72), et comprenant un élément de contact (1) à presser doté d'une partie de pression (2), d'une partie de liaison (3), d'une partie de compensation (4), d'une partie de pied (5) et d'une partie de blocage (6), la partie de compensation (4) étant réalisée de manière élastique et étant conçue de façon à être comprimée vers la partie de pied (5) lors d'un mouvement longitudinal de la partie de pression dans une direction longitudinale de l'élément de contact (1) à presser et de façon à réduire ainsi sa dilatation longitudinale (100), la partie de pied (5) élément de contact (1) à presser étant, par matière, disposée sur une partie de l'une desdites pistes conductrices (70) du substrat (7), et la partie de blocage (6) étant conçue et prévue pour s'appuyer par une surface de blocage (600) sur une contre-surface de blocage (700) et pour limiter ainsi le mouvement longitudinal de la partie de pression (2) dans la direction longitudinale vers la partie de pied (5), **caractérisé en ce que**
la contre-surface de blocage (700) est agencée sur un corps en matériau isolant (72) du substrat (7) ou sur une piste conductrice (70) du substrat (7), en particulier la piste conductrice (70) sur laquelle est également disposée la partie de pied (5).

2. Ensemble semi-conducteur de puissance selon la revendication 1, dans lequel
la partie de liaison (3) de l'élément de contact (1) à presser présente une première et une deuxième surface principale (30, 32) agencées parallèlement l'une à l'autre et réalisées chacune de manière plane.

3. Ensemble semi-conducteur de puissance selon l'une des revendications précédentes, dans lequel
la partie de compensation (4) de l'élément de contact (1) à presser présente un arc ou une pluralité d'arcs (40, 42), de préférence adjacents les uns aux autres.

4. Ensemble semi-conducteur de puissance selon la revendication 3, dans lequel
la partie de compensation (4) de l'élément de contact (1) à presser est en forme de S.

5. Ensemble semi-conducteur de puissance selon les revendications 2 à 4, dans lequel
une première partie d'arc (44) d'un premier arc (40) de la partie de compensation (4) de l'élément de contact (1) à presser fait saillie de la première surface principale (30) dans une direction normale.

6. Ensemble semi-conducteur de puissance selon les revendications 2 à 5, dans lequel
une deuxième partie d'arc (46) d'un deuxième arc (42) de la partie de compensation (4) de l'élément de contact (1) à presser fait saillie de la deuxième surface principale (32) dans la direction normale.

7. Ensemble semi-conducteur de puissance selon l'une des revendications précédentes, dans lequel
l'ensemble de l'élément de contact (1) à presser est formé à partir d'une tôle plate ou d'une bande métallique plate au moyen d'un procédé d'estampage.

8. Ensemble semi-conducteur de puissance selon l'une des revendications précédentes, dans lequel
la partie de blocage (6) de l'élément de contact (1) à presser est réalisée en forme de broche et la surface de blocage (600) est agencée à l'extrémité de la partie de blocage (6) située dans la direction longitudinale.

9. Ensemble semi-conducteur de puissance selon l'une des revendications précédentes, dans lequel
la partie de blocage (6) de l'élément de contact (1) à presser est réalisée sous la forme de deux parties de blocage partiel (60, 62) et la partie de compensation (4) ou une partie de celle-ci est agencée entre les deux parties de blocage partiel (60, 62) ou la partie de compensation (4) est réalisée sous la forme de deux parties de compensation partielle et la partie de blocage (6) ou une partie de celle-ci est agencée entre les deux parties de compensation partielle.

10. Ensemble semi-conducteur de puissance selon l'une des revendications précédentes, dans lequel
le substrat est formé d'une céramique isolante comme support des pistes conductrices ou comme circuit imprimé rigide ou comme circuit imprimé flexible.

11. Ensemble semi-conducteur de puissance comprenant un boîtier, un substrat (7) entouré par celui-ci et un ensemble semi-conducteur de puissance selon l'une des revendications 1 à 10.

12. Ensemble semi-conducteur de puissance selon la revendication 11, dans lequel
le boîtier comporte un dispositif de guidage, notamment un puits, dans lequel la partie de liaison (3) est agencée au moins partiellement et de manière mobile dans la direction longitudinale.
